# EUROPEAN PATENT SPECIFICATION

(11) **EP 2 553 713 B1**
(45) Date of publication and mention of the grant of the patent: **01.03.2017**
(21) Application number: 11762920.4
(22) Date of filing: 30.03.2011
(51) Int. Cl.: H01L 21/027, B29C 33/38, B29C 33/42, B29C 59/02, B28B 11/08, B82Y 10/00, G03F 7/00, B82Y 40/00

(54) **NANOIMPRINTING METHOD AND METHOD FOR PRODUCING A MOLD**
NANOPRÄGEVERFAHREN UND VERFAHREN ZUR HERSTELLUNG EINER FORM
PROCÉDÉ DE NANOIMPRESSION ET PROCÉDÉ DE PRODUCTION DE MOULE

(30) Priority: 30.03.2010 JP 2010076992
(43) Date of publication of application: 06.02.2013
(73) Proprietor: FUJIFILM Corporation, Tokyo 106-8620 (JP)
(72) Inventor: WAKAMATSU, Satoshi, Minamiashigara-shi Kanagawa 250-0193 (JP); OMATSU, Tadashi, Minamiashigara-shi Kanagawa 250-0193 (JP)
(74) Representative: Hoffmann Eitle
(86) International application number: PCT/JP2011/058658
(87) International publication number: WO 2011/122704

(56) References cited:
- WO-A1-2009/067241
- WO-A1-2009/099630
- WO-A2-2005/033797
- WO-A2-2007/123805
- US-A1- 2007 170 617
- US-A1- 2010 072 671
- HIROSHIMA H ET AL: "Elimination of pattern defects of nanoimprint under atmospheric conditions", JAPANESE JOURNAL OF APPLIED PHYSICS, JAPAN SOCIETY OF APPLIED PHYSICS, JP , vol. 42, no. 6B 1 June 2003 (2003-06-01), pages 3849-3853, XP002518676, ISSN: 0021-4922, DOI: 10.1143/JJAP.42.3849 Retrieved from the Internet: URL:10.1143/JJAP.42.3849

## Description

### Technical Field

The present invention is related to a nanoimprinting method that transfers the shapes of protrusions and recesses of a mold onto a photocuring composition layer formed on a substrate, by placing the mold and the photocuring composition layer in close contact. The present invention is also related to a method for producing a mold that produces a new mold employing the nanoimprinting method.

### Background Art

There are known nanoimprinting techniques, for transferring the shapes of protrusions and recesses of a mold having a pattern of protrusions and recesses in units of several 10' s of nm to several 100' s of nm onto a photocuring composition layer formed on a substrate by placing the mold and the photocuring composition layer in close contact.

In these nanoimprinting techniques, there are cases in which atmospheric gas, present during close contact of the mold and the photocuring composition layer, remains between the mold and the substrate after the close contact. The residual gas may cause defects to occur in the transferred pattern.

U.S. Patent Application Publication No. 20090140458 proposes the use of a porous mold or a porous substrate, through which residual gas can pass, as a method for reducing the amount of residual gas.

PCT Japanese Publication No. 2007-509769 proposes to saturate atmospheric gas with helium or the like, or to reduce the pressure of the atmospheric gas, to reduce the amount of residual gas.

Performing the process for closely contacting a mold and a photocuring composition layer in a vacuum to reduce the amount of residual gas may also be considered.

However, in the case that the mold and the photocuring composition layer are placed in close contact in a vacuum, a problem occurs, that the depressurized atmosphere causes the photocuring composition to volatilize, resulting in defects being generated in a transferred pattern. This problem occurs conspicuously with low viscosity (low molecular) photocuring compositions that have superior fine pattern forming properties, which also have greater volatilization properties.

It is preferable for the thickness of a photocuring composition coated on a substrate to be thin such that residual film after imprinting becomes thin, in order to improve the fine processing accuracy of the substrate. However, if the coating thickness of the photocuring composition layer is thin, influence exerted by the aforementioned volatilization may cause fluctuations to be generated in the thickness of the photocuring composition. Such fluctuations may cause defects to occur in a transferred pattern due to local insufficiencies of the photocuring composition.

US 2007/0170617 A1 describes a method for patterning first and second substrates in a nanoimprint lithography system, the method including, inter alia, positioning the first substrate on a first substrate chuck; positioning a nanoimprint material on the first substrate; obtaining a spatial relationship between the first substrate and a nanoimprint mold assembly and imprinting a pattern in the nanoimprint material on the first substrate with the nanoimprint mold assembly while concurrently positioning the second substrate on a second substrate chuck; separating the nanoimprint mold assembly from the nanoimprint material on the first substrate; positioning a nanoimprint material on the second substrate; removing the first substrate from the first substrate chuck while concurrently obtaining a spatial relationship between the second substrate and the nanoimprint mold assembly and imprinting a pattern in the nanoimprint material on the second substrate with the nanoimprint mold assembly; and separating the nanoimprint mold assembly from the nanoimprint material on the second substrate, with the first and second substrates being subjected to substantially the same process conditions.

US 2010/0072671 A1 describes a nanoimprint lithography template includes a rigid support layer, a cap layer, and a flexible cushion layer positioned between the support layer and the cap layer. Treating an imprint lithography template includes heating the template to desorb gases from the template. Heating the template includes radiating the template at a selected wavelength with, for example, infrared radiation. The selected wavelength may correspond to a wavelength at which the template material is strongly absorbing.

Hiroshima H. et al. studied the generation mechanism of bubble defects in air using molds having many recessed square patterns and photocurable liquid polymer with a viscosity of 64 Mpas. The bubble defects could be eliminated using ambient gas condensation (see Japanese Journal of Applied Physics, Japan Society of applied Physics, vol. 42, no. 6B, June 2003, pages 3849-3853).

The present invention has been developed in view of the foregoing circumstances. It is an object of the present invention to provide a nanoimprinting method that suppresses volatilization of a photocuring composition while reducing residual gas in a nanoimprinting method, and a method for producing a mold.

### Disclosure of the Invention

A nanoimprinting method of the present invention comprises:
placing a mold having protrusions and recesses thereon in close contact with a photocuring composition layer formed on a substrate, to transfer the shapes of the protrusions and recesses onto the photocuring composition layer; and is characterized by:
   one or both of the mold and the substrate being formed by quartz; and
   the mold and the photocuring composition layer being placed into close contact with a gas having at least 70% He by volume and a pressure within a range from 30kPa to 70kPa interposed therebetween.

A method for producing a mold of the present invention is characterized by:
employing the nanoimprinting method of the present invention to produce a new mold having protrusions and recesses which are inverted with respect to those of the mold.

In the nanoimprinting method and the method for producing a mold of the present invention, a mold having protrusions and recesses thereon is placed in close contact with a photocuring composition layer formed on a substrate, to transfer the shapes of the protrusions and recesses onto the photocuring composition layer. At this time, one or both of the mold and the substrate being formed by quartz, and the mold and the photocuring composition layer are placed into close contact with a gas having at least 70% He by volume interposed therebetween. Therefore, at least the He within residual gas passes through the mold or the substrate formed by quartz, thereby reducing the amount of residual gas to an allowable level. Meanwhile, in the case that the gas is less than 70% He by volume, the amount of residual gas that leaks out will be reduced, and the amount of residual gas may not be reduced to an allowable level.

In addition, the gas pressure is set to be within a range from 30kPa to 70kPa, which is a range that enables obtainment of a residual gas reducing effect and is also a range in which the photocuring composition does not volatilize. Therefore, the amount of residual gas can be reduced, while suppressing volatilization of the photocuring composition. As a result, the occurrence of defects in a transferred pattern due to volatilization of the photocuring composition or by residual gas can be reduced.

### Brief Description of the Drawings

Figure 1 is a diagram that schematically illustrates the configuration of an imprinting apparatus.
Figure 2 is a diagram that illustrates an example of a pattern of protrusions and recesses formed on a mold.
Figure 3 is a graph that illustrates the relationship between pressure after depressurization and the number of defects in Experimental Example 1.
Figure 4 is a graph that illustrates the relationship between pressure after depressurization and the number of defects in Experimental Example 2.
Figure 5 is a graph that illustrates the relationship between pressure after depressurization and the number of defects in Experimental Example 3.
Figure 6 is a graph that illustrates the relationship between pressure after depressurization and the number of defects in Experimental Example 4.
Figure 7 is a graph that illustrates the relationship between pressure after depressurization and the number of defects in Experimental Example 5.

### Best Mode for Carrying Out the Invention

Hereinafter, an embodiment of the nanoimprinting method of the present invention will be described. The nanoimprinting method of the present invention transfers the shapes of protrusions and recesses onto a photocuring composition layer, by placing a mold having the protrusions and recesses and the photocuring composition layer formed on a substrate in close contact. First, the mold, the substrate, and the photocuring composition will be described.

### [Regarding the Mold]

The mold is a structure having a desired pattern of protrusions and recesses on the surface thereof. In the case that the substrate is formed by a material other than quartz, a mold formed by quartz (quartz mold) is employed. In the case that the substrate is formed by quartz, a quartz mold may be employed, or a mold formed by another material (a Si mold, for example), may be employed.

Here, a method for producing a Si mold, as an example of a mold formed by a material other than quartz, will be described. First, a Si substrate is coated by a photoresist liquid such as a novolac resin or an acrylic resin by the spin coat method or the like, to form a photoresist layer. Next, a laser beam (or an electron beam) is irradiated onto the Si substrate, to expose a predetermined pattern on the surface of the photoresist layer. Then, the photoresist layer is developed to remove the exposed portions. Finally, selective etching is performed by RIE or the like, using the photoresist layer after the exposed portions are removed, to obtain the Si mold having the desired pattern.

The quartz mold can be produced by performing a process for producing an inverted mold by a method for producing a mold of the present invention to be described later twice. Specifically, the method for producing a mold of the present invention is applied, using an original mold (a quartz mold or a mold formed by a material other than quartz) having desired protrusions and recesses, to produce an inverted mold having protrusions and recesses inverse those of the original mold. Then, the method for producing a mold of the present invention is applied to the produced inverted mold, to produce a mold having protrusions and recesses inverse those of the inverted mold, that is, a replicated mold (quartz mold) having the same protrusions and recesses as the original mold. It is preferable for the thickness of the quartz mold to be within a range from 0.3mm to 10mm. If the thickness of the quartz mold is less than 0.3mm, it is likely to become damaged during handling or due to pressure during imprinting. Meanwhile, if the thickness of the quartz mold is greater than 10nm, the dispersion speed of He within the quartz will become slow, and a long amount of imprinting time will become necessary to reduce defects.

Note that the mold may be that which has undergone a mold release process to improve separation properties between the photocuring composition and the mold. Examples of such a mold include: those which have been processed by silicone or fluorine silane coupling agents. Commercially available mold release agents such as Optool DSX by Daikin Industries K.K. and Novec EGC-1720 by Sumitomo 3M K.K. may be favorably employed.

### [Regarding the Substrate]

In the case that the mold is formed by a material other than quartz, a substrate formed by quarts (quartz substrate) is employed. In this case, the quartz substrate is not particularly limited, as long as it has light transmissive properties and has a thickness of 0.3mm or greater, and may be selected as appropriate according to intended use. Examples of the quartz substrate include: those in which the surface of a quartz substrate is coated with a silane coupling agent; those in which a metal layer of Cr, W, Ti, Ni, Ag, Pt, or Au is provided on the surface of a quartz substrate; those in which a metal oxide layer of CrO₂, WO₂, or TiO₂ is provided on the surface of a quartz substrate; and those in which a metal layer of Cr, W, Ti, Ni, Ag, Pt, or Au or a metal oxide layer of CrO₂, WO₂, or TiO₂ is provided on the surface of a quartz substrate, which is then coated with a silane coupling agent. The thickness of the metal layer or the metal oxide layer is generally 30nm or less, and preferably 20nm or less. If the thickness of the metal layer or the metal oxide layer exceeds 30nm, the UV transmissive properties deteriorate, and curing failure of the photocuring composition becomes likely to occur.

In addition, the expression "light transmissive properties" refers to a degree of light transmissivity that enables sufficient curing of an imprinting resist film when light enters the side of the substrate opposite that on which the photocuring composition film is formed. Specifically, the "light transmissive properties" refers to light transmissivity of 5% or greater with respect to light having a desired wavelength from the side of the substrate opposite that on which the photocuring composition film is formed to the side of the substrate on which the photocuring composition film is formed.

It is preferable for the thickness of the quartz substrate to be within a range from 0.3mm to 10mm. If the thickness of the quartz substrate is less than 0.3mm, it is likely to become damaged during handling or due to pressure during imprinting. Meanwhile, if the thickness of the quartz substrate is greater than 10mm, the dispersion speed of He within the quartz will become slow, and a long amount of imprinting time will become necessary to reduce defects.

Meanwhile, substrates to be employed with the quartz mold are not limited with regard to the shape, the structure, the size or the material thereof, and may be selected according to intended use. With respect to the shape of the substrate, a substrate having a discoid shape may be utilized in the case that nanoimprinting is performed to produce a data recording medium. With respect to the structure of the substrate, a single layer substrate maybe employed, or a laminated substrate may be employed. With respect to the material of the substrate, the material may be selected from among known materials for substrates, such as silicon, nickel, aluminum, glass, and resin. These materials may be utilized singly or in combination. The substrate may be produced, or may be those which are commercially available.

The thickness of the substrate is not particularly limited, and may be selected according to intended use. However, it is preferable for the thickness of the substrate to be 0.05mm or greater, and more preferably 0.1mm or greater. If the thickness of the substrate is less than 0.05mm, there is a possibility that the substrate will flex during close contact with the mold, resulting in a uniform close contact state not being secured.

### [Regarding the Photocuring Composition]

The photocuring composition of the present invention includes a polymerizable compound (A) and a photopolymerization initiating agent (B) at least. Generally, photocuring compositions employed in photo nanoimprinting methods include a polymerizable compound that have polymerizable functional groups, and a photopolymerization initiating agent that initiates polymerizing reactions of the polymerizable compound when irradiated with light. The photocuring compositions may further include solvents, surfactants, antioxidant agents, etc., as necessary.

### -Polymerizable Compound (A)-

The polymerizable compound (A) of the present invention is a compound that has polymerizable functional groups. Examples of the polymerizable functional groups include cationic polymerizable functional groups and radical polymerizable functional groups. The radical polymerizable functional groups are preferred. Examples of preferred cationic polymerizable groups are: epoxy groups and oxetane groups. Examples of the radical polymerizable functional groups include functional groups having ethylene unsaturated bonds, of which (meth) acryl groups, vinyl groups, and aryl groups are preferred. The preferred number of polymerizable functional groups to be included in the polymerizable compound (A) of the present invention is 1 to 4 from the viewpoints of curing properties and viscosity, and more preferably 1 to 2.

The preferred carbon number of the polymerizable compound (A) is from 10 to 30 from the viewpoints of curing properties and viscosity, more preferably from 10 to 20, and most preferably from 10 to 16. In addition, the molecular weight of the polymerizable compound is 150 to 400 from the viewpoints of viscosity and volatilization properties, and more preferably 150 to 300.

If a low viscosity compound is employed as the polymerizable compound (A), the mold filling properties during imprinting are improved. That is, when patterns are mass produced by a nanoimprinting method, the curing composition fills the mold without the contact pressure of the mold being high. This is favorable from the viewpoints of mold durability and throughput. However, low viscosity compounds have low molecular weights, and there is a tendency for such compounds to have high volatilization properties. For this reason, it is necessary to consider the balance between viscosity and volatilization properties when selecting a compound.

From the viewpoint of curing properties, it is preferable for the amount of the polymerizable compound included in the photocuring composition of the present invention to be within a range from 50% to 99.5% by mass of all components excluding a solvent, more preferably within a range from 70% to 99% by mass, and most preferably within a range from 90% to 99% by mass. In the case that the polymerizable compound (A) is a compound having two polymerizable functional groups, it is preferable for the amount of the polymerizable compound (A) included in the photocuring composition of the present invention to be within a range from 1% to 70% by mass, more preferably within a range from 5% to 60% by mass, and most preferably within a range from 10% to 40% by mass. In the case that the polymerizable compound (A) is a compound having three polymerizable functional groups, it is preferable for the amount of the polymerizable compound (A) included in the photocuring composition of the present invention to be within a range from 1% to 70% by mass, more preferably within a range from 3% to 50% by mass, and most preferably within a range from 5% to 40% by mass. That is, from the viewpoints of improving composition viscosity, dry etching resistance, imprinting compatibility, curing properties, etc., it is preferable for the polymerizable compound (A) to be used in combination with another polymerizable compound in the case that the polymerizable compound (A) has two or more polymerizable functional groups.

As described above, the photocuring composition may include a polymerizable compound different from the polymerizable compound (A), to improve composition viscosity, dry etching resistance, imprinting compatibility, curing properties, etc. Examples of the polymerizable compound include: polymerizable unsaturated compounds having groups with 1 to 6 ethylene unsaturated bonds; compounds having oxirane rings (epoxy compounds); vinyl ether compounds; styrene derivatives; compounds having fluorine atoms; propenyl ether; and butenyl ether. From the viewpoint of curing properties, polymerizable unsaturated compounds having groups with 1 to 6 ethylene unsaturated bonds are preferred.

The polymerizable unsaturated compounds having groups with 1 to 6 ethylene unsaturated bonds (polymerizable unsaturated compounds having 1 to 6 functions) will be described.

Specific examples of polymerizable unsaturated compounds having groups with 1 ethylene unsaturated bond include: 2-acryloyloxy ethylphthalate; 2-acryloyloxy 2-hydroxyethylphthalate; 2-acryloyloxy ethylhexahydrophthalate; 2-acryloyloxy propylphthalate; 2-ethyl-2-butylpropanediol acrylate; 2-ethylhexyl (meth) acrylate; 2-ethylhexyl carbitol (meth) acrylate; 2-hydroxybutyl (meth) acrylate; 2-hydroxyethyl (meth) acrylate; 2-hydroxypropyl (meth) acrylate; 2-methoxyethyl (meth) acrylate; 3-methoxybutyl (meth) acrylate; 4-hydroxybutyl (meth) acrylate; acrylic acid dimmer; benzyl (meth) acrylate; butanediol mono (meth) acrylate; butoxyethyl (meth) acrylate; butyl (meth) acrylate; cetyl (meth) acrylate; denatured ethylene oxide (hereinafter, referred to as "EO"); cresol (meth) acrylate; dipropylene glycol (meth) acrylate; ethoxylated phenyl (meth) acrylate; ethyl (meth) acrylate; isoamyl (meth) acrylate; isobutyl (meth) acrylate; isooctyl (meth) acrylate; cyclohexyl (meth) acrylate; isobornyl (meth) acrylate; dicyclopentanyl (meth) acrylate; dicyclopentanyloxyethyl (meth) acrylate;; isomyristyl (meth) acrylate; lauryl (meth) acrylate; methoxydipropylene glycol (meth) acrylate; methoxytripropylene glycol (meth) acrylate; methoxypolyethylene glycol (meth) acrylate; methoxytriethylene glycol (meth) acrylate; methyl (meth) acrylate; neopentylglycolbenzoate (meth) acrylate; nonylphenoxypolyethylene glycol (meth) acrylate;; nonylphenoxypolypropylene glycol (meth) acrylate; octyl (meth) acrylate; paracumylphenoxyethylene glycol (meth) acrylate; epichlorohydrine (hereinafter referred to as "ECH") denatured phenoxyacrylate; phenoxyethyl (meth) acrylate; phenoxydiethylene glycol (meth) acrylate; phenoxyhexaethylene glycol (meth) acrylate; phenoxytetraethylene glycol (meth) acrylate; polyethylene glycol (meth) acrylate; polyethylene glycol-polypropylene glycol (meth) acrylate; polypropylene glycol (meth) acrylate; stearyl (meth) acrylate; EO denatured succinate (meth) acrylate; tert-butyl (meth) acrylate; tripromophenyl (meth) acrylate; EO denatured tripromophenyl (meth) acrylate; tridodecyl (meth) acrylate; p-isopropenyl phenol; styrene; α-methyl styrene; and acrylonitryl.

Among the above, benzyl (meth) acrylate; dicyclopentanyl (meth) acrylate; dicyclopentanyloxyethyl (meth) acrylate; isobornyl (meth) acrylate; and adamantyl (meth) acrylate can be favorably employed in the present invention. These compounds may be utilized either singly or in combinations of two or more.

Multifunctional polymerizable unsaturated compounds having groups that include two ethylene unsaturated bonds are also preferred as the polymerizable compound. Examples of polymerizable unsaturated compounds having groups with 2 ethylene unsaturated bonds include: diethylene glycol monoethylether (meth) acrylate; dimethylol dicyclopentane di (meth) acrylate; di (meth) acrylated isocyanulate; 1,3-butyrene glycol di (meth) acrylate; 1,4-butanediol di (meth) acrylate; EO denatured 1,6-hexanediol di (meth) acrylate; ECH denatured 1,6-hexanediol di (meth) acrylate; aryloxy polyethylene glycol acrylate; 1,9-nonanediol di (meth) acrylate; EO denatured bisphenol A di (meth) acrylate;; PO denatured bisphenol A di (meth) acrylate; denatured bisphenol A di (meth) acrylate; EO denatured bisphenol F di (meth) acrylate; ECH denatured hexahydrophthalic diacrylate; hydroxypivalate neopentyl glycol di (meth) acrylate; neopentyl glycol di (meth) acrylate; EO denatured neopentyl glycol diacrylate; propylene oxide (hereinafter, referred to as "PO") denatured neopentyl glycol diacrylate; caprolactone denatured hydroxypivalate ester neopentyl glycol; stearic acid denatured pentaerythritol di (meth) acrylate; ECH denatured phthalate di (meth) acrylate; poly (ethylene glycol-tetramethylene glycol) di (meth) acrylate; poly (propylene glycol-tetramethylene glycol) di (meth) acrylate; polyester (di) acrylate; polyethylene glycol di (meth) acrylate; polypropylene glycol di (meth) acrylate; ECH denatured propylene glycol di (meth) acrylate; silicone di (meth) acrylate; triethylene glycol di (meth) acrylate; tetraethylene glycol di (meth) acrylate; dimethylol tricyclodecane di (meth) acrylate; neopentyl glycol denatured trimethylol propane di (meth) acrylate; tripropylene glycol di (meth) acrylate; EO denatured tripropylene glycol di (meth) acrylate; triglycerol di (meth) acrylate; dipropylene glycol di (meth) acrylate; divinyl ethylene urea; and divinyl propylene urea.

Among these, neopentyl glycol di (meth) acrylate; 1,9-nonanediol di (meth) acrylate; tripropylene glycol di (meth) acrylate; tetraethylene glycol di (meth) acrylate; hydroxypivalate neopentyl glycol di (meth) acrylate; polyethylene glycol di (meth) acrylate; and the like are particularly preferred.

Examples of multifunctional polymerizable unsaturated compounds having groups with 3 ethylene unsaturated bonds include: ECH denatured glycerol tri (meth) acrylate; EO denatured glycerol tri (meth) acrylate; PO denatured glycerol tri (meth) acrylate; pentaerythritol triacrylate; EO denatured phosphate triacrylate; trimethylol propane tri (meth) acrylate; caprolactone denatured trimethylol propane tri (meth) acrylate; EO denatured trimethylol propane tri (meth) acrylate; PO denatured trimethylol propane tri (meth) acrylate; tris (acryloxyethyl) isocyanylate; dipentaerythritol hexa (meth) acrylate; caprolactone denatured dipentaerythritol hexa (meth) acrylate; dipentaerythritol hydroxy penta (meth) acrylate; alkyl denatured dipentaerythritol penta (meth) acrylate; dipentaerythritol poly (meth) acrylate; alkyl denatured dipentaerythritol tri (meth) acrylate; ditrimethylol propane tetra (meth) acrylate; pentaerythritol ethoxy tetra (meth) acrylate; and pentaerythritol tetra (meth) acrylate.

Among these, EO denatured glycerol tri (meth) acrylate; PO denatured glycerol tri (meth) acrylate; trimethylol propane tri (meth) acrylate; EO denatured trimethylol propane tri (meth) acrylate; PO denatured trimethylol propane tri (meth) acrylate; dipentaerythritol hexa (meth) acrylate; pentaerythritol ethoxy tetra (meth) acrylate; pentaerythritol tetra (meth) acrylate; and the like are favorably employed in the present invention.

Examples of compounds having oxirane rings (epoxy compounds) include: hydrogenated compounds, such as polybasic acid polyglycidyl esters, polyhydroxy alcohol polyglycidyl ethers, polyoxyalkylene glycol polyglycidyl ethers, aromatic polyol polyglycidyl ethers, and aromatic polyol polyglycidyl ethers; urethane polyepoxy compounds; and epoxylated polybutadienes. These compounds may be used singly or in combinations of two or more.

Specific examples of the compounds having oxirane rings (epoxy compounds) that can be favorably utilized in the present invention include: polyether polyol polyglycidyl ethers, obtained by adding one or more types of alkylene oxides to an aliphatic polyhydroxy alcohol, such as bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, hydrogenated bisphenol A diglycidyl ether, hydrogenated bisphenol F diglycidyl ether, hydrogenated bisphenol S diglycidyl ether, 1,4-butanediol diglycidyl ether, 1,6-hexanediol diglycidyl ether, glycerin triglycidyl ether, trimethylol propane triglycidyl ether, polyethylene glycol diglycidyl ether, polypropylene glycol diglycidyl ether, ethylene glycol, propylene glycol, and glycerin; aliphatic long chain dibasic acid diglycidyl esters; aliphatic higher alcohol monoglycidyl ethers; polyether alcohol monoglycidyl ethers, such as phenol, cresol, butylphenol, and those obtained by adding alkylene oxide to phenol, cresol, and butylphenol; and higher aliphatic acid glycidyl esters.

Among these, bisphenol A diglycidyl ether, bisphenol F diglycidyl ether, hydrogenated bisphenol A diglycidyl ether, hydrogenated bisphenol F diglycidyl ether, 1,4-butanediol diglycidyl ether, 1,6-hexanediol diglycidyl ether, glycerin triglycidyl ether, trimethylol propane triglycidyl ether, neopentyl glycol diglycidyl ether, polyethylene glycol diglycidyl ether, and polypropylene glycol diglycidyl ether are particularly preferred.

Commercially available products that can be favorably utilized as glycidyl containing compounds include: UVR-6216 (by Union Carbide Co.); Glycydol, AOEX24, and Cyclomer A200 (by Daicel Chemical Industries, K.K.); Epicoat 828, Epicoat 812, Epicoat 1031, Epicoat 872, and Epicoat CT508 (by Yuka Shell, K.K.); and KRM-2400, KRM-2410, KRM-2408, KRM-2490, KRM-2720, andKRM-2750 (by Asahi Denka Industries, K.K.) . These products may be used either singly or in combinations of two or more.

Vinyl ether compounds may be used in combination as the polymerizable compound to be employed by the present invention. Known vinyl ether compounds may be selected. Examples of vinyl ether compounds include: 2-ethylhexyl vinyl ether; butanediol-1,4-divinyl ether; diethylene glycol monovinyl ether; ethylene glycol divinyl ether; triethylene glycol divinyl ether; 1,2-propanediol divinyl ether; 1,3-propanediol divinyl ether; 1,3-butanediol divinyl ether; 1,4-butanediol divinyl ether; 1,4-butanediol vinyl ether; tetramethylene glycol divinyl ether; neopentyl glycol divinyl ether; trimethylol propane trivinyl ether; trimethylol ethane trivinyl ether; hexanediol divinyl ether; tetraethylene glycol divinyl ether; pentaerythritol divinyl ether; pentaerythritol trivinyl ether; pentaerythritol tetravinyl ether; sorbitol tetravinyl ether; sorbitol pentavinyl ether; ethylene glycol diethylene vinyl ether; triethylene glycol diethylene vinyl ether; ethylene glycol dipropylene vinyl ether; triethylene glycol diethylene vinyl ether; trimethylol propane triethylene vinyl ether; trimethylol propane diethylene vinyl ether; pentaerythritol diethylene vinyl ether; pentaerythritol triethylene vinyl ether; pentaerythritol tetraethylene vinyl ether; 1,1,1-tris [4-(2-vinyloxyethoxy) phenyl] ethane; and bisphenol A divinyloxyethyl ether.

In addition, styrene derivatives may be utilized as the polymerizable compound of the present invention. Examples of styrene derivatives include: styrene; p-methyl styrene; p-methoxy styrene; β-methyl styrene; α-methyl styrene; p-methoxy-β-methyl styrene; and p-hydroxy styrene.

In addition, compounds having fluorine atoms, such as: trifluoroethyl (meth) acrylate; pentafluoroethyl (meth) acrylate; (perfluorobutyl) ethyl (meth) acrylate; perfluorobutyl-hydroxy dipropyl (meth) acrylate; (perfluorohexyl) ethyl (meth) acrylate; octafluoropentyl (meth) acrylate; perfluorooctyl ethyl (meth) acrylate; and tetrafluoro propyl (meth) acrylate, may be used in combination with the polymerizable compound, in order to improve coating properties and release properties with respect to the mold.

Propenyl vinyl ethers and butenyl ethers may be utilized as the polymerizable compound of the present invention. Examples of the propenyl vinyl ethers and butenyl ethers include: 1-dodecyl-1-propenyl ether; 1-dodecyl-1-butenyl ether; 1-butaneoxymethyl-2-norbornene; 1-4-di (1-butaneoxy) butane; 1,10-di (1-butaneoxy) decane; 1,4-di (1-butaneoxymethyl) cyclohexane; diethylene glycol di (1-butenyl) ether; 1,2,3-tri (1-butaneoxy) propane; and propenyl ether propylene carbonate.

### -Photopolymerization Initiating Agent (B)-

A photopolymerization initiating agent is included in the nanoimprinting curing composition of the present invention. Any photopolymerization initiating agent may be employed in the present invention as long as it is a compound that generates active species that polymerizes the polymerizable compound described above when light is irradiated thereon. Radical polymerization initiating agents that generate radicals when irradiated with light and cationic polymerization initiating agents that generate acids when irradiated with light are preferred as the photopolymerization initiating agent. Although radical polymerization initiating agents are more preferable, the type of photopolymerization initiating agent is selected as appropriate according to the type of polymerizable groups of the polymerizable compound. That is, it is necessary for a photopolymerization initiating agent which is active with respect to the wavelength of a light source to be employed, and generates active species suited to the different reaction formats (radical polymerization or cationic polymerization) to be selected as the photopolymerization initiating agent of the present invention. In the present invention, a plurality of types of photopolymerization initiating agents may be employed in combination.

The amount of the photopolymerization initiating agent to be included in the photocuring composition is within a range from 0.01% to 15% by mass, preferably a range from 0.1% to 12% by mass, and most preferably a range from 0.2% to 7% by mass. In the case that two or more types of photopolymerization initiating agents are employed, the combined amount thereof should fall within the above ranges.

If the amount of the photopolymerization initiating agent is 0.01% by mass or greater, sensitivity (curing speed properties), resolution properties, line edge roughness properties, and coated film strength tend to improve, which is preferable. Meanwhile, if the amount of the photopolymerization initiating agent is 15% by mass or less, light transmissive properties, coloration properties, and handling properties tend to improve, which is preferable. Heretofore, various favorable photopolymerization initiating agents and amounts thereof to be added have been investigated with respect to compositions that include dyes and/or colorants for use in ink jet printers and compositions for use in liquid crystal display color filters. However, there are no reports regarding favorable photopolymerization initiating agents and amounts thereof to be added with respect to photocuring compositions for nanoimprinting. That is, in cases that compositions include dyes and/or colorants, such dyes and colorants may function as radical trapping agents, which may influence photopolymerization properties and sensitivity. The amount of photopolymerization initiating agent to be added for such uses is optimized taking this point into consideration. On the other hand, dyes and/or colorants are not essential components for the photocuring composition of the present invention. Therefore, there are cases in which the optimal range for the amount of photopolymerization initiating agent to be added will differ from those for compositions to be employed by ink jet printers and for compositions for use in liquid crystal display color filters.

Acylphosphine oxide series compounds and oxime ester series compounds are preferred for utilization as radical photopolymerization initiating agents in the present invention, from the viewpoints of curing sensitivity and absorption properties. Commercially available initiating agents may be employed as the photopolymerization initiating agent. Examples of such commercially available initiating agents include: Irgacure™ 2959 (1-[4-(2-hydroxyethoxy) phenyl]-2-hydroxy-2-methyl-1-propane-1-one; Irgacure™ 184 (1-hydroxycyclohexylphenylketone); Irgacure™ 500 (1-hydroxycyclohexylphenylketone, benzophenone); Irgacure™ 651 (2,2-dimethoxy-1,2-diphenylethane-1-one); Irgacure™ 369 (2-benzyl-2-dimethylamino-1-(4-morpholinophenyl) butanone-1); Irgacure™ 907 (2-methyl-1 [4-methyltiophenyl]-2-morpholinopropane-1-one); Irgacure™ 819 (bis (2,4,6-trimethylbenzoyl)-phenyl phosphine oxide); Irgacure™ 1800 (bis (2,6-dimethoxybenzoyl)-2,4,4-trimethyl-pentylphosphine oxide, 1-hydroxy-cyclohexyl-phenyl-ketone); Irgacure™ OXE01 (1,2-octanedione, 1-[4-(phenylthio) phenyl]-2-(O-benzoyl oxime)); Darocur™ 1173 (2-hydroxy-2-methyl-1-phenyl-1-propane-1-one); Darocur™ 1116, 1398, 1174, and 1020; and CGI242 (ethanone, 1-[9-ethyl-6-(2-methylbenzoyl)-9H-carbazole-3-yl]-1-(O-acetylox ime)), available from CIBA; Lucirin TPO (2,4,6-trimethylbenzoyl diphenyl phosphine oxide); and Lucirin TPO-L (2,4,6-trimethylbenzoyl phenylethoxy phosphine oxide), available from BASF; ESACURE 1001M (1-[4-benzoyl phenylsulfanyl] phenyl-2-methyl-2-(4-methylphenylsufonyl) propane-1-one); and N-1414, available from ESACURE Japan Siber Hegner; Adekaoptomer™ N-1414 (carbazole/phenone series); Adekaoptomer™ N-1717 (acridine series); and Adekaoptomer™ N-1606 (triadine series), available from Asahi Denka; TFE-triadine (2-[2-(furane-2-yl)vinyl]-4,6-bis (trichloromethyl)), by Miwa Chemical; TME-triadine (2-[2-(5-methylfurane-2-yl) vinyl]-4,6-bis (trichloromethyl)-1,3,5 triadine), by Miwa Chemical; MP-triadine (2-(4-mthoxyphenyl)-4,6-bis (trichloromethyl)-1,3,5-triadine), by Miwa Chemical; TAZ-113 (2-[2-(3,4-dimethoxy phenyl) ethenyl]-4,6-bis (trichloromethyl)-1,3,5-triadine) by Midori Chemical; TAZ-108 (2-(3,4-dimethoxy phenyl)-4,6-bis (trichloromethyl)-1,3,5-triadine) by Midori Chemical; benzophenone; 4,4'-bisdiethyl amino benzophenone; methyl-2-benzophenone; 4-benzoyl-4'-methyldiphenyl sulfide; 4-phenyl benzophenone; ethyl Michler's ketone; 2-chloro thioxanthone; 4-isopropyl thioxanthone; 2,4-diethyl thioxanthone; 1-chloro-4-propoxy thioxanthone; 2-methyl thioxanthone; thioxanthone ammonium salt; benzoin; 4,4'-dimethoxy benzoin; benzoin methyl ether; benzoin ethyl ether; benzoin isopropyl ether; benzoin isobutyl ether; benzyl dimethyl ketal;1,1,1-trichloro acetophenone; diethoxy acetophenone, dibenzosuberone; o-benzoyl methyl benzoate; 2-benzoyl naphthalene; 4-benzoyl biphenyl; 4-benzoyl diphenyl ether; 1,4-benzoyl benzene; benzyl; 10-butyl-2-chloroacridone; [4-(methylphenylthio) phenyl] phenylmethane; 2-ethyl anthraquinone; 2,2-bis(2-chlorophenyl) 4,5,4',5'-tetrakis (3,4,5-trimethoxy phenyl) 1,2'-biimidazole; 2,2-bis(o-chlorophenyl) 4,5,4',5'-tetraphenyl-1,2'-biimidazole; tris (4-dimethyl amino phenyl) methane; ethyl-4-(dimethyl amino) benzoate; 2-(dimethyl amino) ethyl benzoate; and butoxyethyl-4-(dimethyl amino) benzoate.

Note that in the present invention, "light" includes radiation, in addition to light having wavelengths in the ultraviolet spectrum, the near ultraviolet spectrum, the far ultraviolet spectrum, the visible spectrum, and the infrared spectrum. The radiation includes microwaves, electron beams, EUV, and X rays, for example. In addition, laser light, such as those emitted by a 248nm excimer laser, a 193nm excimer laser, and a 172nm excimer laser may be employed. These light beams may be monochromatic light beams (single wavelength light beams) which have passed through optical filters, or light beams that include a plurality of different wavelengths (compound light beams). Multiple exposures may be performed. It is also possible to expose the entire surface after the pattern is formed, in order to improve film strength and etching resistance.

It is necessary to select the photopolymerization initiating agent which is utilized in the present invention according to the wavelength of the light source to be utilized. In addition, it is preferable for the photopolymerization initiating agent to be that which does not generate gas during mold pressing and exposure. If gas is generated, the mold will be contaminated, and frequent cleansing of the mold will become necessary. In addition, problems, such as the photocuring composition deforming within the mold, resulting in deterioration of accuracy of transferred patterns, will occur.

It is preferable for the photopolymerization initiating agent (B) of the present invention to be a radical polymerization initiating agent that generates radicals when irradiated with light, and for the polymerizable compound (A) to be a radical polymerizable compound.

### (Other Components)

The photocuring composition of the present invention may include other components, such as surfactants, antioxidant agents, solvents, and polymer components, within a range that will not take away from the advantageous effects of the present invention. It is preferable for the photocuring composition of the present invention to include at least one other component selected from a group consisting of: fluorochemical surfactants; silicone series surfactants; fluorine/silicone series surfactants, and antioxidant agents.

### -Surfactants-

It is preferable for the photocuring composition of the present invention to include a surfactant. The amount of surfactant to be included in the photocuring composition of the present invention is within a range from 0.001% to 5% by mass, preferably within a range from 0.002% to 4% by mass, and most preferably within a range from 0.005% to 3% by mass. In the case that two or more types of surfactants are to be included, the combined amount thereof should fall within the above ranges. If the amount of surfactant included in the composition is within a range from 0.001% to 5% by mass, coating uniformity is favorable, and deterioration of mold transfer properties due to excessive amounts of surfactant.

It is preferable for the surfactant to include at least one of fluorochemical surfactants, silicone series surfactants, and fluorine/silicone series surfactants. It is more preferable for both a fluorochemical surfactant and a silicone series surfactant or a fluorine/silicone series surfactant to be included, and most preferable for a fluorine/silicone series surfactant to be included. Note that anionic surfactants are preferred as the fluorochemical surfactant and the silicone series surfactant. Here, the "fluorine/silicone series surfactants" refer to surfactants that satisfy the requirements of both fluorochemical surfactants and silicone series surfactants.

By employing the surfactants such as those described above, it becomes possible to resolve problems associated with coating failure, such as striations that occur when the photocuring composition is coated onto the substrate on which various layers such as silicon, nickel, aluminum, glass, and resin are formed, and scale like patterns (uneven drying of resist film). In addition, the fluidity of the photocuring composition with respect to the interiors of the cavities of the recesses of the mold, the release properties between the mold and the composition, and close contact properties between the composition and the substrate are improved. In addition, it becomes possible to decrease the viscosity of the composition. Particularly, the coating uniformity of the photocuring composition of the present invention can be greatly improved by adding the surfactant. Thereby, favorable coating properties can be obtained regardless of the size of the substrate during coating using a spin coater or a slit scan coater.

Examples of anionic fluorochemical surfactants that can be employed in the present invention include: Fluorad FC-430 and Fluorad FC-431 (by Sumitomo 3M, K.K.) ; Surflon S-382 (by Asahi Glass Chemical, K.K.) ; EFTOP EF-122A, 122B, 122C, EF-121, EF-126, EF-127, and MF-100 (by K.K. Tochem Products) ; PF-636, PF-6320, PF-656, and PF-6520 (by OMNOVA Solutions, Inc.); Ftergent FT250, FT251, and DFX18 (by K.K. Neos) ; Unidyne DS-401, DS-403, DS-451 (By Daikin Industries, K.K.) ; andMegaface 171, 172, 173, 178K, and 178A (by Dainippon Ink Chemical Industries, K.K.).

Examples of anionic silicone series surfactants include: SI-10 Series (by Takemoto Oil and Fat, K.K.); Megaface Peintad 31 (by Dainippon Ink Chemical Industries, K.K.); and KP-341 (by Shinetsu Chemical Industries, K.K.).

In addition, examples of the fluorine/silicone series surfactants include: X-70-090, X-70-091, X-70-092, andX-70-093 (by Shinetsu Chemical Industries, K.K.); and Megaface R-08 and XRB-4 (by Dainippon Ink Chemical Industries, K.K.).

### -Antioxidant Agent-

Further, it is preferable for the nanoimprinting curing composition of the present invention to include a known antioxidant agent. The amount of the antioxidant agent to be included in the photocuring composition is within a range from 0.01% to 10% by mass, and preferably a range from 0.2% to 5% by mass with respect to the total amount of the polymerizable compound. In the case that two or more types of antioxidant agents are employed, the combined amount thereof should fall within the above ranges.

The antioxidant agent suppresses color degradation due to heat and light irradiation, as well as color degradation due to various acidic gases such as ozone, activated oxygen, NOₓ, and SOₓ (x is an integer). Particularly in the present invention, addition of the antioxidant agent results in advantages such as coloration of the cured film being prevented, and decreases in film thickness due to decomposition being reduced. Examples of the antioxidant agent include: hydrazides; hindered amine series antioxidant agents; nitrogen containing heterocyclic ring mercapto series compounds; thioether series antioxidant agents; hindered phenol series antioxidant agents, ascorbic acids; zinc sulfate; thiocyanates; thiourea derivatives; sugars; nitrites; thiosulfonates; and hydroxyl amine derivatives. Among these, hindered phenol series antioxidant agents and thioether series antioxidant agents are preferred from the viewpoints of coloration of the cured film and decreased film thickness.

Commercially available antioxidant agents include: Irganox 1010, 1035, 1076, and 1222 (by Ciba Geigy, K.K.); Antigene P, 3C, FR, Sumilizer S, and Sumilizer GA80 (by Sumitomo Chemical Industries, K.K.); and ADK STAB AO70, AO80, and AO503 (by K.K. ADEKA). The antioxidant agents may be used singly or in combination.

### -Solvent-

The nanoimprinting curing composition of the present invention may also include a solvent according to various needs. It is particularly preferable for the curing composition to include a solvent when forming patterns having film thicknesses of 500nm or less. Preferred solvents are those having boiling points within a range from 80°C to 200°C at atmospheric pressure. Any solvent may be employed as long as it is capable of dissolving the composition. However, preferred solvents are those that include at least one of an ester structure, a ketone structure, hydroxy groups, and an ether structure. Specific examples of preferred solvents include: propylene glycol monomethyl ether acetate; cyclohexanone; 2-heptanone; gammabutylolactone; propylene glycol Monomethyl ether; and ethyl lactate. These solvents may be employed singly or in combinations as mixtures. Solvents that contain propylene glycol monomethyl ether acetate are most preferred from the viewpoint of coating uniformity.

The amount of the solvent to be included in the composition of the present invention is optimally adjusted according to the viscosity of the components other than the solvent, the coating properties, and the target film thickness. From the viewpoint of coating properties, however, it is preferable for the amount of the solvent to be within a range from 0% to 95% by mass with respect to the composition, and more preferably within a range from 0% to 90% by mass. In the case that a pattern having a film thickness of 100nm or less is to be formed, it is preferable for the amount of the solvent to be within a range from 1% to 30% by mass, more preferably within a range from 1% to 20% by mass, and most preferably within a range from 1% to 10% by mass.

### -Polymer Components-

The composition of the present invention may include multifunctional oligomers having greater molecular weights than the other multifunctional polymerizable monomers within a range that enables the objectives of the present invention to be achieved, in order to further increase bridging density. Examples of multifunctional oligomers having photoradical polymerization properties are acrylate oligomers, such as: polyester acrylate; urethane acrylate; polyether acrylate; and epoxy acrylate. It is preferable for the amount of oligomer components to be added to be within a range from 0% to 30% by mass with respect to the components of the composition excluding the solvent, more preferably within a range from 0% to 20% by mass, still more preferably within a range from 0% to 10% by mass, and most preferably within a range from 0% to 5% by mass.

The nanoimprinting curing composition of the present invention may further include polymer components, from the viewpoints of improving dry etching resistance, imprinting properties, and curing properties. Polymers having polymerizable functional groups at the side chains thereof are preferred as the polymer components. From the viewpoint of compatibility with the polymerizable compound, it is preferable for the average molecular weight of the polymer components to be within a range from 2000 to 100000, and more preferably within a range from 5000 to 50000. It is preferable for the amount of the polymer components to be added to be within a range from 0% to 30% by mass with respect to the components of the composition excluding the solvent, more preferably within a range from 0% to 20% by mass, still more preferably within a range from 0% to 10% by mass, and most preferably 2% by mass or less. If the amount of polymer components having molecular weights of 2000 or greater is 30% by mass or less with respect to components of the composition of the present invention excluding the solvent, pattern formation properties are improved. In addition, it is preferable for resin components to be minimized from the viewpoint of pattern formation properties. It is preferable fro resin components to not be included, excluding surfactants and fine amount of additives.

In addition to the aforementioned components, the nanoimprinting curing composition of the present invention may further include: mold release agents; silane coupling agents; polymerization prohibiting agents; ultraviolet ray absorbing agents; light stabilizing agents; aging preventing agents; plasticizing agents; close contact promoting agents; thermal polymerization initiating agents; coloring agents; elastomer particles; photooxidation proliferating agents; photobase generating agents; basic compounds; fluidity adjusting agents; defoaing agents; and dispersing agents as necessary.

The photocuring composition of the present invention can be prepared by mixing each of the aforementioned components. In addition, the photocuring composition of the present invention can be prepared as a solution, by performing filtering through a filter having a mesh size within a range from 0.05µm to 5.0µm after mixing the components. Mixing and dissolving of the photocuring composition is generally performed within a temperature range from 0°C to 100°C. The filtering may be performed in a plurality of steps, or repeated a plurality of times. In addition, the filtered liquid may be filtered again. The material of the filter which is utilized in the filtering operation is not particularly limited. Examples of the material of the filter include: polyethylene resin; polypropylene resin; fluorine resin; and nylon resin.

It is preferable for the viscosity of the components of the photocuring composition of the present invention excluding the solvent at 25°C to be within a range from 1 to 100mPa·s, more preferable within a range from 2 to 50mPa·s, and most preferably within a range from 5 to 30mPa·s. By setting the viscosity to be within an appropriate range, the rectangular shaping properties of the pattern are improved, and further, the thickness of residual film can be kept low.

### [Regarding the Nanoimprinting Method]

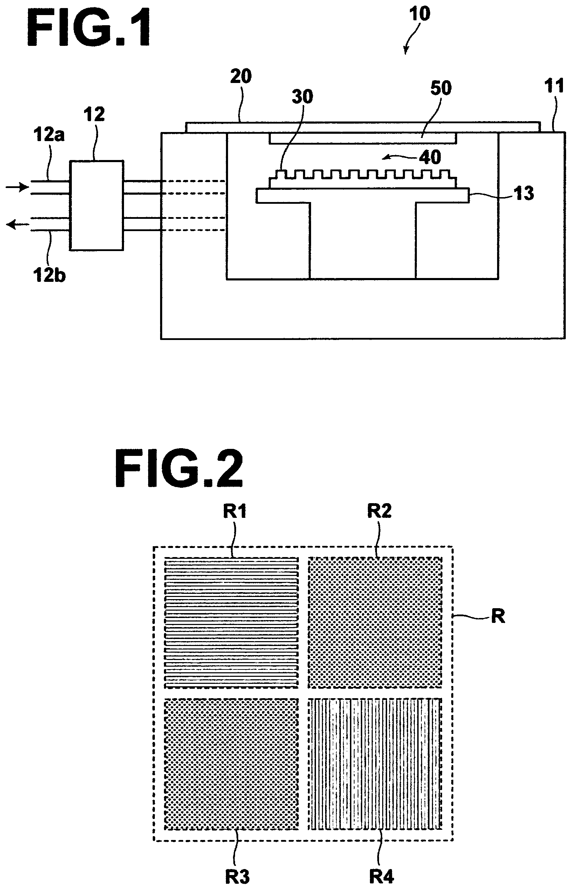

Next, the nanoimprinting method of the present invention will be described with reference to Figure 1. Note that a case will be described in which the substrate is a quartz substrate. Figure 1 is a diagram that schematically illustrates the configuration of a nanoimprinting apparatus 10. The nanoimprinting apparatus 10 is equipped with: a chamber main body 11 having an opening at the upper portion thereof; a pressure adjusting mechanism 12 connected to the chamber main body 11 via pipe conduits; and a pressing member 13. The interior of the chamber is partitioned from the exterior, by the upper portion of the chamber main body 11 being sealed by a quartz substrate 20 placed thereon. The exterior of the chamber is the atmosphere, in which the concentration of He is 0.1% by volume. The pressure adjusting mechanism 12 is connected to a gas supply source (He or the like) via a pipe 12a, and connected to a vacuum pump via a pipe 12b. The pressure adjusting mechanism 12 adjusts the gaseous environment of the interior of the chamber, by substituting gases, depressurizing, and pressurizing the interior of the chamber.

First, the photocuring composition is coated on the quartz substrate 20 by the spin coat method or the like, to form a photocuring composition film 50. Then, the quartz substrate 20 and a mold 30 are placed such that the surface of the mold 30 having protrusions and recesses thereon faces the surface of the quartz substrate 20 having the photocuring composition film 50 thereon.

Next, the pressure adjusting mechanism 12 replaces the gas within the interior of the chamber until the concentration of He therein becomes 95% by volume (replacing step). It is preferable for the concentration of He in the interior of the chamber to be at least 70% by volume, from the viewpoint of reducing residual gas to an allowable level. It is more preferable for the concentration of He in the interior of the chamber to be 90% by volume or greater because residual gas can be more effectively reduced, and most preferably to be 95% by volume or greater. Note that in the case that the concentration of He is less than 70% by volume, components other than He will not pass through the quartz substrate 20 and remain as residual gas. In addition, the residual gas cannot be sufficiently dissolved in the photocuring composition. The residual gas may cause defects to be generated in a transferred pattern.

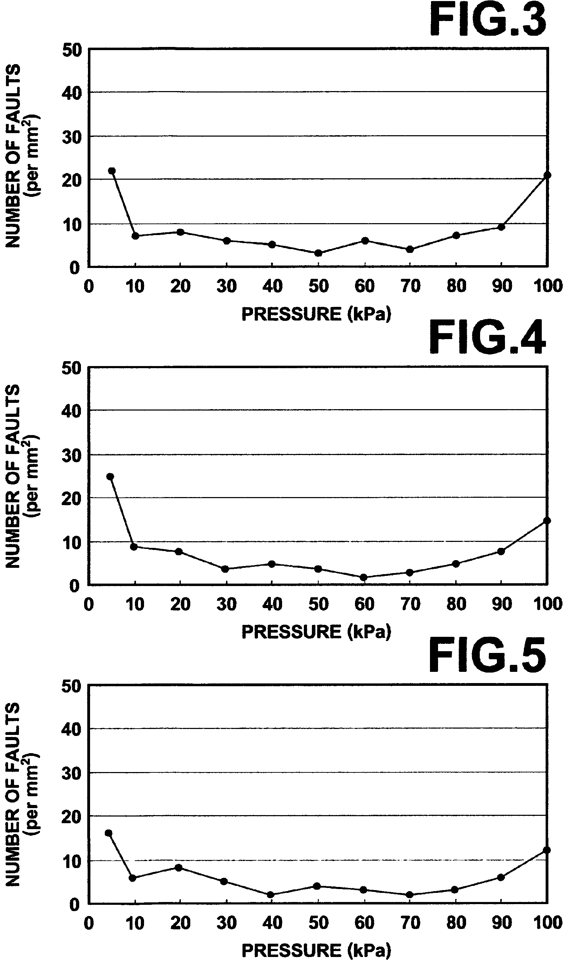

Next, the pressure adjusting mechanism 12 depressurizes the interior of the chamber to 30kPa or greater and 70kPa or less (depressurizing step). Depressurization of the interior of the chamber yields the advantageous effect of reducing residual gas. At the same time, this range of pressure is that in which the photocuring composition is not likely to volatilize. It is more preferable for the pressure of the interior of the chamber to be within a range from 40kPa to 60kPa because residual gas can be more effectively reduced (refer to the graphs of Figures 3 through 6, to be described later).

Next, the pressing member 13 is elevated by a drive mechanism (now shown), to press the mold 30 which is held on the pressing member 13 against the quartz substrate 20. Thereby, the mold 30 and the photocuring composition layer 50 formed on the quartz substrate 20 are placed in close contact (close contacting step). Here, the expression "the mold 30 and the photocuring composition layer 50 formed on the quartz substrate 20 are placed in close contact" refers to a state in which a sufficient close contact state is realized not only with respect to the protrusions of the protrusions and recesses of the mold 30 to be transferred, but with respect to the recesses as well.

Next, atmospheric pressure (approximately 101kPa) exerted from the exterior side of the quartz substrate 20 presses the quartz substrate 20 against the mold 30 (or the mold 30 against the quartz substrate 20), and this pressurized state is maintained for 5 seconds (pressing step). At this time, the partial pressure of He at the side of the quartz substrate 20 toward the mold 30 is higher than the partial pressure of He at the side of the quartz substrate 20 toward the exterior. Because He passes through quartz, at least He from among gases remaining in a space 40 between the quartz substrate 20 and the mold 30 pass through the quartz substrate 20 and leak toward the exterior, thereby reducing the amount of residual gas.

Next, a high pressure mercury lamp (with a peak exposure wavelength of 365nm) irradiates ultraviolet rays at an exposure intensity of 25mW/cm² for 10 seconds in the state that the mold 30 is pressed against the substrate 20 having the photocuring composition 50 coated thereon, to cure the photocuring composition 50 (exposure step). The mold 30 is separated from the cured photocuring composition 50. Note that during this exposure, it is preferable for the exposure intensity to be within a range from 1mW/cm² to 50mW/cm². By setting the exposure intensity to 1mW/cm² or greater, the exposure time can be shortened, thereby improving productivity. By setting the exposure intensity to 50mW/cm² or less, deterioration of the properties of a permanent film due to side reactions can be suppressed. It is desirable for the exposure amount to be within a range from 5mJ/cm² to 1000mJ/cm². At exposure amounts less than 5mJ/cm², the exposure margins becomes too narrow, photocuring becomes insufficient, and problems, such as adhesion of non reacting substances onto the mold, become more likely to occur. Meanwhile, if the exposure amount exceeds 1000mJ/cm², there is a possibility that the permanent film will deteriorate due to decomposition of the photocuring composition 50.

The shapes of the protrusions and recesses of the mold 30 are transferred onto the photocuring composition layer 50 by the process described above. Note that a case was described above in which the substrate is formed by quartz, the substrate is placed at the upper portion of the chamber main body 11, and the mold is placed on the pressing member 13. Alternatively, in the case that the mold is formed by quartz, the mole may be placed on the upper portion of the chamber main body 11, and the substrate may be placed on the pressing member 13. In this case, gas that remains between the substrate and the quartz mold will be expelled toward the exterior by passing through the quartz mold.

Next, Experimental Examples 1 through 5 will be described.

### [Experimental Example 1]

### <Mold>

A 0.525mm thick 4 inch Si wafer having pattern regions of protrusions and recesses in quartered sections (R1 through R4 of Figure 2) of a 1mm² region R was employed as a mold. A mold release process with Optool DSX using the dip coat method is administered to the surface of the mold. The patterns of protrusions and recesses within region R include regions in which 2000 grooved lines having lengths of 400µm, widths of 100nm, pitches of 200nm, and depths of 100nm are formed, and 2000 by 2000 holes as dots having diameters of 100nm, pitches of 200nm, and depths of 100nm are formed.

### <Substrate>

A 0.7mm thick 6 inch quartz wafer was employed as the substrate. The surface of the quartz wafer was processed with KBM-5103 (by Shin-Etsu Chemical Industries, K.K.), which is a silane coupling agent, to improve close contact properties with respect to the photocuring composition.

### <Photocuring Composition>

A photocuring composition was prepared by adding a polymerization initiating agent B (2% by mass), a surfactant W-1 (0.1% by mass), a surfactant W-2 (0.04% by mass), an antioxidant A-1 (1% by mass), and an antioxidant A-2 (1% by mass) to a polymerizable compound A. In this experimental example, benzyl acrylate, which is a low viscosity substance having a comparatively high volatility, was selected in order to confirm the suppressing effect with respect to defects caused by volatilization of the photocuring composition. With respect to compositions having poor solubility, it is preferable to add a small amount of acetone or acetic ether to dissolve the composition, and then to remove the solvent. In addition, the composition was diluted with propylene glycol monomethyl ether acetate such that the film thickness of the photocuring composition becomes 60nm when coating the photocuring composition on the substrate.

### • Polymerizable Compound

A: benzyl acrylate (Viscoat #160 by Osaka Organic Chemical Industries, K.K.)

### • Photopolymerization Initiating Agent

B: 2,4,6-trimethylbenzoyl-ethoxyphenyl-phosphine oxide (Lucirin TPO-L by BASF)

### • Surfactants

W-1: fluorochemical surfactant (fluorochemical surfactant by Tochem Products, K.K.)
W-2: silicone surfactant (Megafac Peintad 31 by Dainippon Ink Chemical Industries, K.K.)

### • Antioxidant Agents

A-1: Sumilizer GA80 by Sumitomo Chemical Industries, K.K.
A-2: ADK STAB AO503 by K.K. ADEKA

### <Imprinting Conditions>

### • Replacing Step

The chamber was sealed with the 0. 7mm thick 6 inch quartz wafer, and the gas within the interior of the chamber was replaced such that the concentration of He therein became 95% by volume.

### • Depressurizing Step

The gaseous pressure within the interior of the chamber is controlled to a desired value by the pressure adjusting mechanism. The gaseous pressure within the interior of the chamber is set to 10kPa, 20kPa,..., 90kPa for the embodiments, and set to 5kPa and 100kPa for the comparative examples.

### • Pressing Step

The mold and the substrate were placed in close contact, then pressed together for 5 seconds by atmospheric pressure (approximately 101kPa).

### • Exposure Step

After the pressing step, a high pressure mercury lamp (having a peak exposure wavelength of 365nm) irradiated ultraviolet rays at an exposure intensity of 25mW/cm² for 10 seconds to cure the photocuring composition 50. Then, the mold was separated from the cured photocuring composition.

### [Experimental Example 2]

A 0.7mm thick 6 inch quartz wafer having pattern regions of protrusions and recesses in quartered sections of a 1mm² region was employed as a mold. A 0.525mm thick 4 inch Si wafer was used as a substrate. Other than these points, all other conditions were the same as those for Experimental Example 1.

### [Experimental Example 3]

A 0.7mm thick 6 inch quartz wafer having pattern regions of protrusions and recesses in quartered sections of a 1mm² region was employed as a mold. A 0.525mm thick 4 inch quartz wafer was used as a substrate. Other than these points, all other conditions were the same as those for Experimental Example 1.

### [Experimental Example 4]

A 7mm thick 6 inch quartz wafer was used as the substrate. The 7mm thick 6 inch quartz wafer was used to seal the chamber, and the gas within the interior of the chamber was replaced such that the concentration of He therein was 70% by volume. Other than these points, all other conditions were the same as those for Experimental Example 1.

### [Experimental Example 5]

N₂ was utilized as the gas that replaces the gas within the interior of the chamber in the replacing step, and the gas within the chamber was adjusted by the pressure adjusting mechanism such that the concentration of N₂ was 95% by volume. In addition, the gaseous pressure within the interior of the chamber was set to 5kPa, 10kPa, 20kPa, ..., 90kPa, 100kPa in the depressurizing step. Other than these points, all other conditions were the same as those for Experimental Example 1.

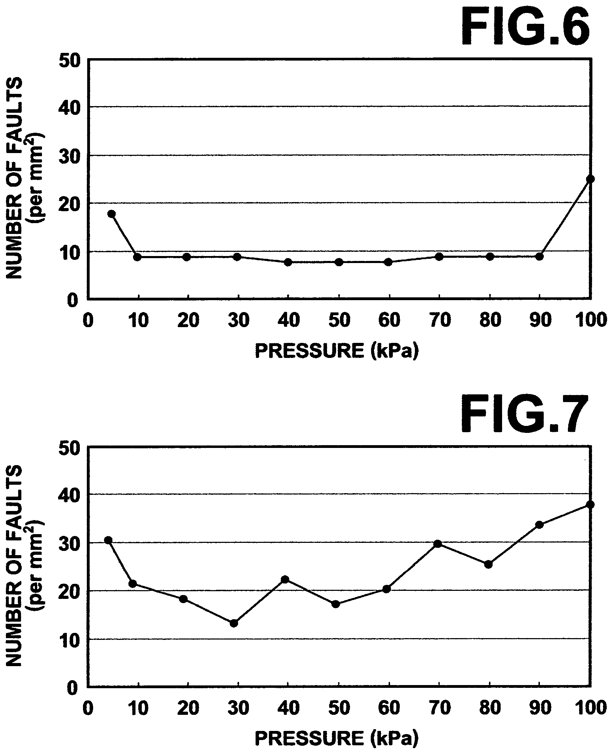

The number of defects per 1mm² was measured for each of a plurality of transferred patterns, formed by setting the depressurization conditions to 5kPa, 10kPa, 20kPa,..., 90kPa, or 100kPa for each of Experimental Examples 1 through 5 by a measuring method to be described later. The results of the measurements are shown in Figures 3 through 7. The results for Experimental Example 1 are shown in Figure 3, the results for Experimental Example 2 are shown in Figure 4, the results for Experimental Example 3 are shown in Figure 5, the results for Experimental Example 4 are shown in Figure 6, and the results for Experimental Example 5 are shown in Figure 7. Here, cases in which the depressurization conditions are 10kPa, 20kPa,..., 90kPa for Experimental Examples 1 through 4 are the embodiments of the present invention, and the other cases are comparative examples.

As illustrated in Figure 3 through 6, the number of defects per 1mm² exceeded the minimum allowable level (10 defects per 1mm²) in the transfer patterns obtained with depressurization conditions of 5kPa and 100kPa (comparative examples). In contrast, the number of defects per 1mm² was less than or equal to the minimum allowable level (10 defects per 1mm²) in the transfer patterns obtained with depressurization conditions of 10kPa, 20kPa,..., 90kPa (embodiments).

In addition, as illustrated in Figures 3 through 6, the number of defects was smaller in cases that the depressurization conditions were in a range from 30kPa to 70kPa than in cases that the depressurization conditions were in a range from 10kPa to 90kPa, and even smaller in cases that the depressurization conditions were within a range from 40kPa to 60kPa.

In nanoimprinting processes, the generation of defects due to residual gas can be suppressed by lengthening the pressing time during the pressing step. However, productivity deteriorates as processing times become longer. Therefore, the amount of time which is necessary to realize a minimum level of allowable number of pattern defects becomes important. Therefore, the present applicants measured the amounts of time necessary to realize 10 defects/mm² for each of Experimental Examples 1 through 5. The results of measurement are shown in Table 1.

**TABLE 1**

| Pressure (kPA) | Pressurization Time until 10 Defects/mm² is reached (seconds) | | | | |
|---|---|---|---|---|---|
| | Example 1 | Example 2 | Example 3 | Example 4 | Example 5 |
| 5 | Not reached | Not reached | Not reached | Not reached | Not reached |
| 10* | 4 | 4 | 4 | 5 | Not reached |
| 20* | 4 | 4 | 4 | 5 | Not reached |
| 30 | 4 | 3 | 3 | 5 | Not reached |
| 40 | 3 | 3 | 3 | 4 | Not reached |
| 50 | 3 | 3 | 3 | 4 | Not reached |
| 60 | 3 | 3 | 3 | 4 | Not reached |
| 70 | 4 | 3 | 3 | 5 | Not reached |
| 80* | 4 | 4 | 4 | 5 | Not reached |
| 90* | 4 | 4 | 4 | 5 | Not reached |
| 100 | 10 | 9 | 7 | 15 | Not reached |

| | | | | | |
|---|---|---|---|---|---|
| * Reference Example | | | | | |

As shown in Table 1, in the comparative examples (the data outside the bold frame), the amount of time necessary to realize 10 defects/mm² exceeded 5 seconds. In contrast, the embodiments (the data inside the bold frame) realized 10 defects/mm² in 5 seconds or less.

### [Method for Measuring the Number of Defects]

Patterned portions were inspected by performing dark field measurements with an optical microscope (magnification: 50x to 1500x). First, 1mm square fields were defined at a magnification of 50x. Next, the measurement fields were scanned, to roughly ascertain the presence of defects. Locations that were suspected as being defects were observed while gradually increasing the magnification, and the numbers of defects in the patterns were counted. Locations at which scattered light, which is not observed in normal patterns but which occur due to residual gas, foreign matter, peeling, and collapse, was observed were judged to be defects in the patterns. The total numbers of defects were counted, including defects caused by factors other than residual gas. Note that defects in patterns can be detected by scattered light at levels of single lines of the linear pattern and single dots of the dot pattern, by dark field measurement.

### [Method for Producing a Mold]

Hereinafter, an embodiment of a method for producing a mold of the present invention will be described. The method for producing a mold of the present invention employs the nanoimprinting method of the present invention to produce a new inverted mold having protrusions and recesses inverse with respect to those of an original mold. In the following description, s substrate ultimately becomes an inverted mold.

First, a resist layer is formed by coating an imprinting resist liquid that includes a photocuring composition onto the surface of a substrate. Then, the original mold is pressed against the resist layer within an He environment. A curing process is administered onto the photocuring composition by UV irradiation while the original mold is being pressed against the resist layer. Thereafter, the original mold is separated from the cured photocuring composition. Thereby, a resist pattern, in which the pattern of protrusions and recesses of the original mold are transferred onto the resist layer, is formed on the substrate.

At this time, a quartz substrate is employed with respect to a Si original mold. The shape, the structure, the size, and the material of a substrate to be used with respect to a quartz original mold is not particularly limited, and such a substrate may be appropriately selected according to the intended use thereof.

Then, dry etching is performed using the resist film having the transferred pattern as a mask, to form a pattern of protrusions and recesses inverse to the pattern of protrusions and recesses of the original mold, having the etched portions as recesses. Thereby, a substrate having a pattern inverse that of the original mold, that is, an inverse mold, is obtained.

Note that in the case that the substrate is of a layered structure that includes a metal layer on the surface thereof, dry etching is performed with respect to the metal layer using the resist film as a mask, to form a pattern of protrusions and recesses based on the pattern of protrusions and recesses of the resist film in the metal layer. Thereafter, dry etching is further performed with the thin metal layer as an etching stop layer, to form a pattern of protrusions and recesses in the substrate. Thereby, a substrate having a pattern inverse that of the original mold, that is, an inverse mold, is obtained.

The dry etching method is not particularly limited as long as it is capable of forming a pattern of protrusions and recesses in the substrate, and may be selected according to specific objectives. Examples of dry etching methods that may be employed include: the ion milling method; the RIE (Reactive Ion Etching) method; the sputter etching method; etc. From among these methods, the ion milling method and the RIE method are particularly preferred.

The ion milling method is also referred to as ion beam etching. In the ion milling method, an inert gas such as Ar is introduced into an ion source, to generate ions. The generated ions are accelerated through a grid and caused to collide with a sample substrate to perform etching. Examples of ion sources include: Kauffman type ion sources; high frequency ion sources; electron bombardment ion sources; duoplasmatron ion sources; Freeman ion sources; and ECR (Electron Cyclotron Resonance) ion sources.

Ar gas may be employed as a processing gas during ion beam etching. Fluorine series gases or chlorine series gases may be employed as etchants during RIE.

## Claims

1. A nanoimprinting method, comprising:
placing a mold (30) having protrusions and recesses thereon in close contact with a photocuring composition layer (50) formed on a substrate (20), to transfer the shapes of the protrusions and recesses onto the photocuring composition layer (50) ; **characterized by**:
one or both of the mold (30) and the substrate (20) being formed by quartz; and
the mold (30) and the photocuring composition layer (50) being placed into close contact with a gas having at least 70% He by volume and a pressure within a range from 30kPa to 70kPa interposed therebetween.

2. A method for producing a mold, **characterized by**:
employing the nanoimprinting method of Claim 1 to produce a new mold having protrusions and recesses which are inverted with respect to those of the mold (30).

## Patentansprüche

1. Nanoimprint-Verfahren, umfassend:
Platzieren einer Form (30) mit Erhebungen und
Vertiefungen darauf in engem Kontakt mit einer Schicht aus einer lichthärtenden Zusammensetzung (50), die auf einem Substrat (20) gebildet ist, um die Formen der Erhebungen und Vertiefungen aus der Schicht aus einer lichthärtenden Zusammensetzung (50) zu übertragen,
**dadurch gekennzeichnet, dass**:
eine(s) oder beide von der Form (30) und dem Substrat (20) aus Quarz gebildet ist/sind und
die Form (30) und die Schicht aus einer lichthärtenden Zusammensetzung (50) in engem Kontakt mit einem dazwischen eingefügten Gas mit mindestens 70% Vol.% He und einem Druck in einem Bereich von 30 kPa bis 70 kPa platziert sind.

2. Verfahren zur Herstellung einer Form, **gekennzeichnet durch**:
Verwenden des Nanoimprint-Verfahrens gemäß Anspruch 1 zur Herstellung einer neuen Form mit Erhebungen und Vertiefungen, die invers zu denen der Form (30) sind.

## Revendications

1. Procédé de nano-impression, comprenant :
le placement d'un moule (30) ayant des saillies et des renfoncements sur celui-ci en proche contact avec une couche de composition photodurcissable (50) formée sur un substrat (20), pour transférer les formes des saillies et des renfoncements sur la couche de composition photodurcissable (50) ; **caractérisé en ce que** :
un du moule (30) et du substrat (20) ou les deux sont formés par du quartz ; et
le moule (30) et la couche de composition photodurcissable (50) sont placés en proche contact avec un gaz ayant au moins 70 % de He en volume et une pression située dans une plage allant de 30 kPa à 70 kPa intercalé entre les deux.

2. Procédé de production d'un moule, **caractérisé par** :
l'utilisation du procédé de nano-impression selon la revendication 1 pour produire un nouveau moule ayant des saillies et des renfoncements qui sont inversés par rapport à ceux du moule (30).
